# EUROPEAN PATENT SPECIFICATION

(11) **EP 0 438 039 B1**
(45) Date of publication and mention of the grant of the patent: **29.03.1995**
(21) Application number: 90850405.3
(22) Date of filing: 13.12.1990
(51) Int. Cl.: H03L 7/08, H03L 7/18

(54) **A method and arrangement for frequency synthesis**
Verfahren und Anordnung zur Frequenzsynthese
Procédé et dispositif pour synthèse de fréquence

(30) Priority: 15.01.1990 SE 9000137
(43) Date of publication of application: 24.07.1991
(73) Proprietor: TELEFONAKTIEBOLAGET L M ERICSSON, 126 25 Stockholm (SE)
(72) Inventor: Dent, Paul Wilkinson, Cary, North Carolina 27513 (US)
(74) Representative: Lövgren, Tage

(56) References cited:
- GB-A- 2 097 206
- US-A- 4 179 670
- US-A- 4 599 579

## Description

The invention relates to frequency synthesis with a controlled oscillator incorporated in a phase-locked loop, in which the frequency of the oscillator output signal is divided periodically with mutually different integers, such that the frequency is, on average, divided by a value which is equal to an integer N plus or minus a numerical fraction whose absolute value is smaller than one. The phase position of pulses generated in this way is compared with the phase position of pulses which originate from a reference signal, therewith forming a phase error signal. In order to suppress periodic variations occurring in a control signal to the oscillator due to phase jitter in the loop, there is added to or subtracted from the phase error signal an accumulated correction value which is dependent on said fraction.

### PRIOR ART

In practice, it is often not possible to change the frequency in sufficiently small increments in a frequency synthesiser in which the frequency of the output signal is only divided with one single integer for each possible, lockable frequency. This is because the smallest frequency increment or step between two lockable frequencies is equal to the frequency at which phase position comparisons are carried out when generating the phase error signal. Consequently, when small frequency increments are desired, it is necessary to carry out the phase position comparisons at a frequency which is so low that the loop locking time is unacceptably long during the frequency changes.

In the case of a frequency synthesiser in which the output signal frequency is divided periodically with an integer in the manner described in the introduction, the phase position comparisons can be carried out at a frequency which is higher than the smallest increment magnitude during the frequency changes. UK Patent Specification GB-A-1560233 describes a frequency synthesiser which operates in accordance with this principle. With a frequency synthesiser of this kind, phase jitter occurs in the phase locked loop due to the fact that the oscillator frequency is divided periodically with a numerical integer, e.g. the numeric values N and N+1. The magnitude of this jitter is at maximum one period of the oscillator output signal, i.e. 2 π radians. The maximum jitter is reduced to 2π/N of the pulses generated when the frequency of the oscillator signal is divided down. This means that the correction value added to or subtracted from the phase error signal must be multiplied by a factor which is proportional to 1/N. It is difficult in practice, however, to achieve sufficient accuracy in multiplication by the inverted value of N for a number of different integers N.

### DISCLOSURE OF THE INVENTION

A solution according to the invention is achieved by the a method according to Claim 1 and an arrangement according to Claim 4.

When practising the present invention, no multiplication is effected with a factor which is proportional to 1/N in order to form the correction value. Instead, the phase error signal is amplified with a factor N prior to adding or subtracting the correction value. This procedure is simpler than the procedure of multiplying the correction value by the factor 1/N. For instance, the phase error signal can be amplified in a separate means, such as an analogue multiplier or a multiplying digital-analogue converter. Amplification can also be effected in conjunction with forming the phase error signal, e.g. by amplifying currents in a so-called charging pump.

Amplification of the phase error signal also affords the advantage that loop amplification, loop damping factor and loop band width are held constant. These parameters would otherwise be dependent on 1/N, as a result of varying the frequency.

### BRIEF DESCRIPTION OF THE DRAWINGS

The invention will now be described in more detail with reference to the accompanying drawings, in which Figure 1 illustrates a known frequency synthesiser, Figure 2 illustrates an exemplifying embodiment of an inventive frequency synthesiser, and Figure 3 illustrates an exemplifying embodiment of a phase comparing and amplifying means which is intended to be incorporated in a frequency synthesiser constructed in accordance with the present invention.

### BEST MODES OF CARRYING OUT THE INVENTION

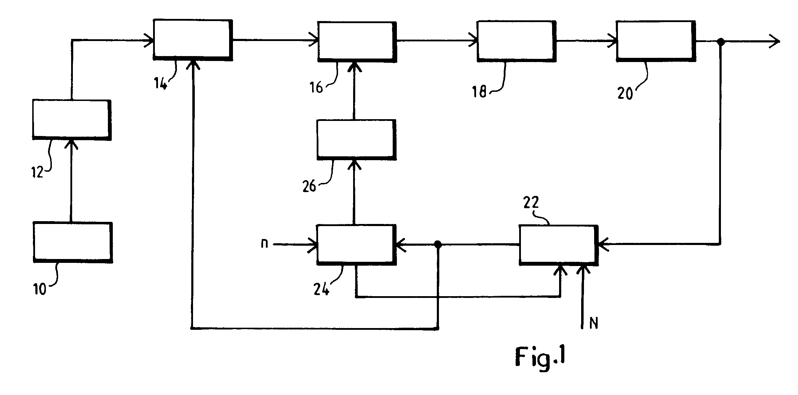

Figure 1 illustrates an example of a frequency synthesiser which operates essentially in accordance with the principle described in the aforesaid UK Patent Specification GB-A-1560233. The reference numeral 20 identifies a controlled oscillator, e.g. a so-called VCO, which generates an output signal of variable frequency. The oscillator 20 is included in a phase locked loop, which also includes a controlled division means 22, in the form of a counter, a phase comparing means 14 and a lowpass filter 18. The frequency of the oscillator output signal is divided periodically in the division means 22 by at least two different integers, for example the numerical values N and N+1. For instance, if the frequency is divided by the number N three times out of four, and by N+1 one time out of four, the frequency will be divided on average by a value N plus the fraction 1/4.

When dividing the frequency, there are formed pulses whose phase positions are compared in the comparator means 14 with the phase positions of pulses supplied from a reference oscillator 10, through a division means 12. As will be evident from the aforegoing, periodic variations of the phase error signal formed by the means 14 will occur, owing to that the fact that the time distance between the reference pulses from the division means 12 is constant whereas the time distance between the pulses from the division means 22 will vary. The mean pulse frequency of the pulses from the means 22, however, is equal to the pulse frequency of the pulses from the means 12. In order to also avoid periodic variation of the control signal delivered to the oscillator 20, there is formed a correction value which is added to or subtracted from the phase error signal in an addition means 16.

The fraction by which the mean division value deviates from the integer or whole number N is hereinafter designated n. The correction value is formulated by accumulating the fraction n in a digital accumulating means 24 for each pulse appearing from the division means 22. The accumulated sum is converted to analogue form in a digital-analogue converter 26, whereafter this sum is added to or subtracted from the phase error signal in the addition means 16. When the accumulated sum exceeds the value 1 there is produced a pulse which is delivered to the division means 22 in order to temporarily change the division number N to N+1 for instance. The division means 22 will therewith count N+1 pulses from the oscillator 20 before delivering the next pulse to the phase comparison means 14 and to the accumulating means 24. At the same time, the accumulated sum is decreased by the value one, whereafter a new sequence can begin.

As beforementioned, the maximum phase jitter of the pulses arriving from the division means 22 is proportional to the inverted value of the numeric value N, and accordingly the correction value supplied to the addition means 16 must also be multiplied by 1/N. This can be achieved, for instance, by adjusting the amplification of the digital-analogue converter for each new value of the division number N, or by multiplying the fraction value n by the inverted value of N.

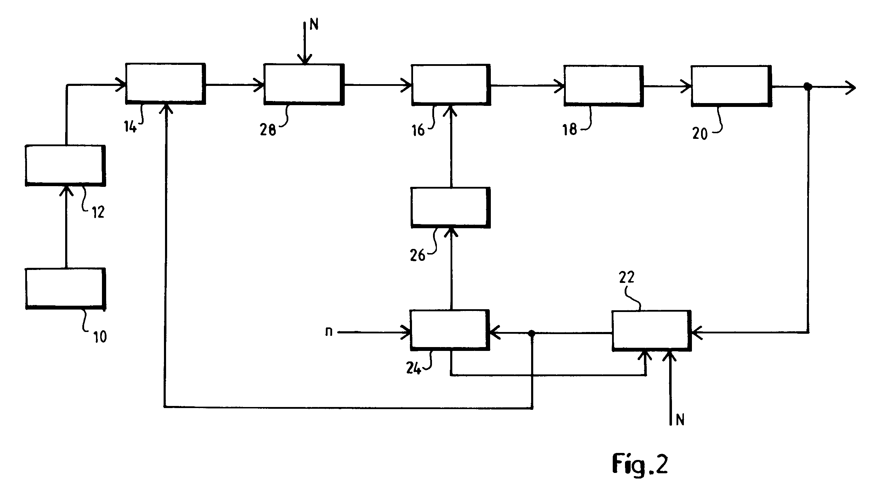

Figure 2 illustrates an exemplifying embodiment of a frequency synthesiser constructed in accordance with the present invention. The embodiment illustrated in Figure 2 includes an amplifying means 28 which is additional to the means or components in the synthesiser illustrated in Figure 1. The function of the amplifying means 28 is to amplify the phase error signal arriving from the phase comparison means 14 with a factor N, prior to adding or subtracting the correction value.

Because the phase error signal is made proportional to the numeric value N, there is no need to make the correction value proportional to the inverted value of N, which is an advantage in comparison with the known synthesiser. Furthermore, loop amplification, damping and bandwidth are also held constant. Frequency division in the division means 22 would otherwise cause these values to vary with changing N.

The amplifying means 28 may, for instance, comprise an analogue multiplier, a multiplying digital-analogue converter, or a programmable damping means.

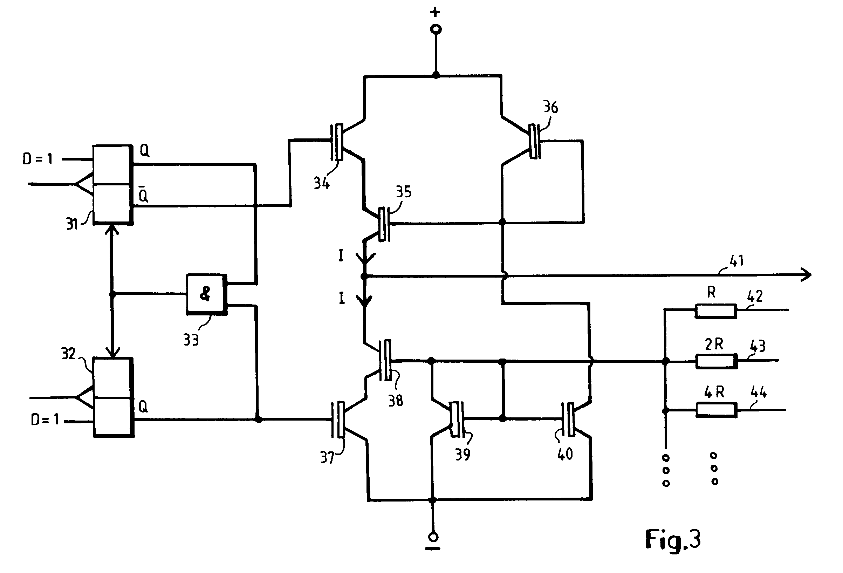

Figure 3 illustrates an exemplifying embodiment of a phase comparing means and an amplifying means which are combined to form one single device. This device is intended to replace the means 14 and 28 of the Figure 2 embodiment. The device includes two D-flip-flops 31, 32, which receive on each of their clock inputs the pulses from a respective pulse train. The flip-flops and an AND-gate 33 generate signals which activate two current mirrors. One current mirror is of the P-type and consists of P-type field effect transistors referenced 34-36. The other current mirror is of the N-type and consists of N-type field effect transistors referenced 37-40. The current mirrors function as two pulse-controlled current generators, of which one, when activated, delivers a positive current I and the other, when activated, delivers a negative current I to a common output line 41. In this way, it is possible to increase or decrease the charge on an integration capacitor over time periods that are dependent on the phase difference between the two pulse trains. For instance, if the pulses deriving from the reference oscillator 10 lie in front of the pulses deriving from the controlled oscillator 20, the capacitor shall be charged over that period of time which lapses from the time that a pulse occurs in the pulse train deriving from the reference oscillator to the time at which a pulse occurs in the pulse train deriving from the controlled oscillator. Because the capacitor is charged, the control voltage of the oscillator 20 will increase and therewith result in an increase in the frequency.

The amplitude of the pulsated currents I supplied respectively to and from the line 41 can be controlled with the aid of digital words on a number of inputs 42, 43, 44, etc.. These inputs are connected to a number of binary weighted resistors having the resistance R, 2R, 4R etc.. Desired amplification with the numeric value N can be achieved by applying this value in binary form to the input 42-44, etc., wherewith the phase error signal will be proportional to N.

It will be understood that the invention can also be applied in conjunction with frequency division integer combinations other than the numeric values N and N+1, for instance with the numeric value N-1. Furthermore, the aforedescribed amplification can be effected with a factor which is proportional, for instance, to the numeric value N+1 instead of the numeric value N.

## Claims

1. A method of forming a frequency control signal for an oscillator (20) which is included in a phase locked loop (14-22) in which pulses are formed by periodically alternating division of the frequency of the oscillator output signal by at least two mutually different integers (N, N+1) such that on average the frequency is divided by a value which deviates from one of said integers (N, N+1) by a numeric fraction whose absolute value is smaller than one, said method includes forming an error signal which is dependent on the phase difference between said pulses and pulses which are derived from a reference signal (10, 12), and adding to or subtracting from the error signal a correction value (16) which is dependent on said numeric fraction, such as to suppress periodic variations of the oscillator control signal caused by phase jitter in the loop, **characterized** by amplifying said error signal with a factor which is proportional to a respective one of said integers (N, N+1) when forming said error signal, such that the error signal will be dependent on both said phase difference and on a respective one of said integers (N, N+1).

2. A method according to Claim 1, **characterized** by forming the error signal with the aid of two pulsated currents of mutually opposite polarity, supplying said currents at a given point (41) and activating said currents by control signals (31:Q̅; 32:Q) which are dependent on said phase difference, and by controlling the amplitude (I) of said currents in a manner such that said amplitude will be proportional to a respective one of said integers (N, N+1).

3. A method according to Claim 1, **characterized** in that when forming the error signal there is first formed a first signal which is dependent on said phase difference (31:Q̅; 32:Q) but not dependent on any one of said integers (N, N+1), and in that the first signal is then amplified with a factor which is proportional to one of said integers (N, N+1).

4. An arrangement of frequency synthesis comprising a controlled oscillator (20) which is included in a phase locked loop (14-22) and which functions to generate a signal of variable frequency, means (22) for forming pulses by the periodic alternating division of the frequency of the oscillator signal by at least two different integers (N, N+1); means (14) for forming an error signal which is dependent on the phase difference between said pulses and pulses which are derived from a reference signal (10; 12); means (24, 26) for forming a correction value by accumulating a numeric fractional value whose absolute value is smaller than one; and means (16) which functions to add the correction value to or subtract said correction value from the error signal, **characterized** in that said means for forming an error signal further includes means (28, 34-40, R, 2R, 4R) which effect amplification of the error signal with a factor which is proportional to a respective one of said integers (N, N+1) in a manner such that the error signal will be dependent on said phase difference and also one of said integers (N, N+1).

5. An arrangement according to Claim 4, **characterized** in that said error signal forming means includes a first means (14) which functions to form a first signal which is dependent on said phase difference but not dependent on any one of said integers (N, N+1), and a second means (28) which functions to amplify said first signal with a factor which is proportional to a respective one of said integers (N, N+1).

6. An arrangement according to Claim 4, **characterized** in that said error signal forming means (14, 28) includes means (31-33) for forming two pulsated control signals which are dependent on said phase difference, two current generating means (34-40) each of which is activated by a respective one of said pulsated control signals, and, in an activated state, to supply respectively a positive or a negative current (I) to a common point (41), and means (R, 2R, 4R) being connectable to receive control signals for forming a control magnitude which is proportional to one of said integers (N, N+1); and in that the current generating means (34-40) can be controlled in a manner such that the amplitude of said currents (I) will be proportional to said control magnitude.

7. An arrangement according to Claim 6, **characterized** in that the current generating means (34-40) comprise two current mirrors.

## Patentansprüche

1. Verfahren zum Bilden eines Frequenzsteuersignals für einen oszillator (20), welcher beinhaltet ist in einer phasenstarren Schleife (14 - 22), in der Impulse gebildet werden durch periodisch alternierende Division der Frequenz des Oszillatorausgangsignals durch zumindest zwei gegenseitig verschiedene natürliche Zahlen (N, N+1), so daß die Frequenz im Mittel geteilt wird durch einen Wert, der abweicht von einer der natürlichen Zahlen (N, N+1) um einen numerischen Anteil, dessen Absolutwert kleiner 1 ist, wobei das verfahren den Schritt des Bildens eines Fehlersignals beinhaltet, welches abhängt von der Phasendifferenz zwischen den Impulsen und Impulsen, welche abgeleitet sind von einem Referenzsignal (10, 12), und Hinzufügen eines Korrekturwerts (16) zu oder Subtrahieren von dem Fehlersignal, welcher abhängig ist von dem numerischen Anteil, um somit periodische Variationen des Oszillatorsignals, verursacht durch Phasenjitter in der Schleife, zu unterdrücken,
**gekennzeichnet** durch den Schritt
Verstärken des Fehlersignals mit einem Faktor, welcher proportional zu einer jeweiligen der natürlichen Zahlen (N, N+1) ist, beim Bilden des Fehlersignals, so daß das Fehlersignal abhängig sein wird von sowohl der Phasendifferenz als auch von einer jeweiligen der natürlichen Zahlen (N, N+1).

2. Verfahren nach Anspruch 1, gekennzeichnet durch den schritt Bilden des Fehlersignals mit der Hilfe von zwei gepulsten strömen gegenseitig entgegengesetzter Polarität, Zuführen der ströme an einem gegebenen Punkt (41) und Aktivieren der ströme durch steuersignale (31; Q; 32; Q), welche abhängig sind von der Phasendifferenz, und durch steuern der Amplitude (I) der Ströme in einer Art und Weise, so daß die Amplitude proportional sein wird zu einer jeweiligen der natürlichen zahlen (N, N+1).

3. Verfahren nach Anspruch 1, dadurch gekennzeichnet**,** daß beim Bilden des Fehlersignals zuerst ein erstes signal gebildet wird, welches abhängt von der Phasendifferenz (31; Q; 32; Q), aber nicht abhängt von irgendeiner der natürlichen Zahlen (N, N+1) und daß das erste signal dann verstärkt wird mit einem Faktor, welcher proportional ist zu einer der natürlichen zahlen (N, N+1).

4. Anordnung zur Frequenzsynthese mit einem gesteuerten Oszillator (20), welcher in einer phasenstarren schleife (14 -22) beinhaltet ist und welcher dient zum Erzeugen eines Signals variabler Frequenz, einer Einrichtung (22) zum Bilden von Impulsen durch periodische alternierende Division der Frequenz des Oszillatorsignals durch zumindest zwei verschiedene natürliche Zahlen (N, N+1); einer Einrichtung (14) zum Bilden eines Fehlersignals, welches abhängt von der Phasendifferenz zwischen den Impulsen und Impulsen, welche abgeleitet sind von einem Referenzsignal (10, 12); einer Einrichtung (24, 26) zum Bilden eines Korrekturwerts durch Akkumulieren eines numerischen Anteilswertes, dessen Absolutwert kleiner als 1 ist; und einer Einrichtung (16), welche dient zum Hinzufügen des Korrekturwerts zu oder subtrahieren des Korrekturwerts von dem Fehlersignal,
dadurch **gekennzeichnet,** daß
die Einrichtung zum Bilden des Fehlersignals weiterhin eine Einrichtung (28, 34 - 40, R, 2R, 4R) beinhaltet, welche eine Verstärkung des Fehlersignals bewirkt mit einem Faktor, welcher proportional ist zu einer jeweiligen der natürlichen Zahlen (N, N+1) in einer Weise, daß das Fehlersignal abhängen wird von der Phasendifferenz und ebenfalls von einer der natürlichen Zahlen (N, N+1).

5. Anordnung nach Anspruch 4, dadurch gekennzeichnet, daß die Fehlersignal-Bildungseinrichtung eine erste Einrichtung (14) beinhaltet, welche dient zum Bilden eines ersten signals, welches abhängt von der Phasendifferenz, aber nicht abhängt von irgendeiner der natürlichen Zahlen (N, N+1), und eine zweite Einrichtung (28, welche dient zum verstärken des ersten Signals mit einem Faktor, welcher proportional ist zu einer jeweiligen der natürlichen Zahlen (N, N+1).

6. Anordnung nach Anspruch 4 dadurch gekennzeichnet, daß die Fehlersignalbildungseinrichtung (14, 28) eine Einrichtung (31 -33) beinhaltet zum Bilden zweier gepulster steuersignale, welche abhängen von der phasendifferenz, zwei stromerzeugungseinrichtungen (34 - 40), von denen jede aktiviert wird durch ein jeweiliges der gepulsten Steuersignale und im aktivierten zustand zum zuführen eines jeweiligen positiven oder negativen Stroms (I) an einen gemeinsamen Punkt (41), und eine Einrichtung (R, 2R, 4R), die verbindbar ist zum Empfangen von steuersignalen, zum Bilden einer Steuergröße, welche proportional ist zu einer der natürlichen Zahlen, (N, N+1), und dadurch, daß die stromerzeugungseinrichtung (34 - 40) gesteuert werden kann in einer Art und Weise, daß die Amplitude der Ströme proportional zur Steuergröße sein wird.

7. Anordnung zu Anspruch 6, dadurch gekennzeichnet, daß die Stromerzeugungseinrichtung auf (34 - 40) zwei Stromspiegel umfaßt.

## Revendications

1. Un procédé de formation d'un signal de commande de fréquence pour un oscillateur (20) qui est inclus dans une boucle d'asservissement de phase (14-22) dans laquelle des impulsions sont formées en alternant périodiquement la division de la fréquence du signal de sortie de l'oscillateur par au moins deux entiers mutuellement différents (N, N+1), de façon qu'en moyenne la fréquence soit divisée par une valeur qui s'écarte de l'un de ces entiers (N, N+1) d'une fraction numérique dont la valeur absolue est inférieure à un, ce procédé comprenant la formation d'un signal d'erreur qui dépend de la différence de phase entre les impulsions précitées et des impulsions qui sont obtenues à partir d'un signal de référence (10, 12), et l'addition au signal d'erreur, ou la soustraction à celui-ci, d'une valeur de correction (16) qui dépend de la fraction numérique précitée, de façon à supprimer des variations périodiques du signal de commande de l'oscillateur qui sont occasionnées par la gigue de phase dans la boucle, **caractérisé** par l'amplification du signal d'erreur avec un facteur qui est proportionnel à l'un respectif des entiers précités (N, N+1), au moment de la formation du signal d'erreur, de façon que le signal d'erreur dépende à la fois de la différence de phase et de l'un respectif des entiers précités (N, N+1).

2. Un procédé selon la revendication 1, **caractérisé** par la formation du signal d'erreur à l'aide de deux courants pulsés de polarité mutuellement opposée, l'application de ces courants à un point donné (41), et l'activation de ces courants par des signaux de commande (31 : Q̅ ; 32 : Q) qui dépendent de la différence de phase, et par la commande de l'amplitude (I) des courants d'une manière telle que cette amplitude soit proportionnelle à l'un respectif des entiers précités (N, N+1).

3. Un procédé selon la revendication 1, **caractérisé** en ce qu'au moment de la formation du signal d'erreur, on forme tout d'abord un premier signal qui dépend de la différence de phase (31 : Q̅ ; 32 : Q) mais qui ne dépend pas de l'un quelconque des entiers précités (N, N+1), et en ce que le premier signal est ensuite amplifié avec un facteur qui est proportionnel à l'un des entiers précités (N, N+1).

4. Un dispositif de synthèse de fréquence, comprenant un oscillateur commandé (20) qui est inclus dans une boucle d'asservissement de phase (14-22) et qui génère un signal de fréquence variable, des moyens (22) pour former des impulsions par la division alternée périodique de la fréquence du signal d'oscillateur par au moins deux entiers différents (N, N+1) ; des moyens (14) pour former un signal d'erreur qui dépend de la différence de phase entre ces impulsions et des impulsions qui sont obtenues à partir d'un signal de référence (10 ; 12) ; des moyens (24, 26) pour former une valeur de correction en accumulant une valeur fractionnaire numérique dont la valeur absolue est inférieure à un ; et des moyens (16) qui additionnent la valeur de correction au signal d'erreur, ou qui soustraient la valeur de correction du signal d'erreur, **caractérisé** en ce que les moyens destinés à former un signal d'erreur comprennent en outre des moyens (28, 34-40, R, 2R, 4R) qui effectuent une amplification du signal d'erreur avec un facteur qui est proportionnel à l'un respectifs des entiers précités (N, N+1), d'une manière telle que le signal d'erreur dépende de la différence de phase et également de l'un des entiers précités (N, N+1).

5. Un dispositif selon la revendication 4, **caractérisé** en ce que les moyens de formation de signal d'erreur comprennent des premiers moyens (14) qui forment un premier signal qui dépend de la différence de phase mais ne dépend pas de l'un quelconque des entiers précités (N, N+1), et des seconds moyens (28) qui amplifient le premier signal avec un facteur qui est proportionnel à l'un respectif des entiers précités (N, N+1).

6. Un dispositif selon la revendication 4, **caractérisé** en ce que les moyens de formation de signal d'erreur (14, 28) comprennent des moyens (31-33) pour former deux signaux de commande impulsionnels qui dépendent de la différence de phase, deux moyens de génération de courant (34-40), chacun d'eux étant activé par l'un respectif des signaux de commande impulsionnels, et appliquant respectivement, dans un état activé, un courant positif ou négatif (I) à un point commun (41), et des moyens (R, 2R, 4R), pouvant être connectés de façon à recevoir des signaux de commande pour former une grandeur de commande qui est proportionnelle à l'un des entiers précités (N, N+1) ; et en ce que les moyens de génération de courant (34-40) peuvent être commandés d'une manière telle que l'amplitude des courants précités (I) soit proportionnelle à la grandeur de commande.

7. Un dispositif selon la revendication 6, **caractérisé** en ce que les moyens de génération de courant (34-40) comprennent deux miroirs de courant.
